# EUROPEAN PATENT SPECIFICATION

(11) **EP 2 953 153 B1**
(45) Date of publication and mention of the grant of the patent: **26.05.2021**
(21) Application number: 13874124.4
(22) Date of filing: 10.12.2013
(51) Int. Cl.: H01L 21/02, H01L 21/265, H01L 27/12, H01L 21/762, H01L 29/34

(54) **PRODUCTION METHOD OF SOI WAFER, AND SOI WAFER**
HERSTELLUNGSVERFAHREN FÜR SOI-WAFER UND SOI-WAFER
PROCÉDÉ DE PRODUCTION D'UNE TRANCHE DE SILICIUM SUR ISOLANT ET TRANCHE DE SILICIUM SUR ISOLANT

(30) Priority: 01.02.2013 JP 2013018833
(43) Date of publication of application: 09.12.2015
(73) Proprietor: Shin-Etsu Handotai Co., Ltd., Tokyo (JP)
(72) Inventor: KOBAYASHI, Norihiro, Annaka-shi Gunma 379-0196 (JP); YOKOKAWA, Isao, Annaka-shi Gunma 379-0196 (JP); AGA, Hiroji, Annaka-shi Gunma 379-0196 (JP)
(74) Representative: Wibbelmann, Jobst
(86) International application number: PCT/JP2013/007248
(87) International publication number: WO 2014/118851

(56) References cited:
- EP-A1- 1 628 339
- WO-A1-2010/050556
- JP-A- 2001 503 568
- JP-A- 2011 135 051
- US-A1- 2003 181 001
- US-A1- 2011 014 775

## Description

### TECHNICAL FIELD

The present invention relates to a method for manufacturing SOI wafer that has used a so-called ion implantation delamination method of manufacturing an SOI wafer by delaminating a wafer that has been ion implanted after bonding.

### BACKGROUND ART

Recently, as a method for manufacturing bonded wafer, a method of manufacturing the bonded wafer by bonding the ion implanted wafer and another wafer and delaminating it at an ion implanted layer (an ion implantation delamination method: a technique that is also called as a Smart-Cut method (TM)) attracts attention.

In the method of manufacturing the SOI wafer by such an ion implantation delamination method, an oxide film is formed on at least one of two silicon wafers, and gas ions such as hydrogen ions, rare gas ions and so forth are implanted from an upper surface of one silicon wafer (a bond wafer) to form a micro bubble layer (a seal layer) in the wafer. Then, a plane on the ion implanted side is adhered to the other silicon wafer (a base wafer) through the oxide film, thereafter heat treatment (delamination heat treatment) is applied to delaminate the one wafer (the bond wafer) in the form of a thin film by using the micro bubble layer as a delamination surface, and heat treatment (bonding heat treatment) is further applied to firmly bond them together into the SOI wafer (see Patent Literatures 1, 2) .

In this method, the SOI wafer having an SOI layer the delamination surface of which is a mirror surface and film thickness of which is uniform can be obtained comparatively with ease. However, in a case of manufacturing the bonded wafer by the ion implantation delamination method, a damaged layer generated by ion implantation is present on the surface of bonded wafer after delaminated, and the surface roughness becomes large in comparison with a mirror surface of a silicon single crystal wafer of a normal product level. Accordingly, in the manufacture by the ion implantation delamination method, it becomes necessary to remove such damaged layer and surface roughness.

Conventionally, in order to remove this damaged layer and so forth, in a final process after the bonding heat treatment, mirror polishing (stock removal: about 100 nm) that is called touch polishing and is extremely reduced in stock removal of polishing has been performed. However, when polishing that includes machining elements is performed on a thin film (the SOI film) of the bonded wafer, since the stock removal of polishing is not uniform in the plane, such a problem arises that the film thickness uniformity of the thin film that has been attained by implantation of hydrogen ions and so forth, delamination is worsened.

As a method for solving such a problem, flattening treatment that improves surface roughness by performing high temperature heat treatment has been conducted in place of the aforementioned touch polishing.

On the other hand, there is a room-temperature mechanical delamination method (also called rT-CCP, SiGen methods) that when hydrogen ions and so forth are to be implanted into the bond wafer, implantation is performed in dose amount that is about 1.5 times that of the Smart-Cut method, thereafter, bonding interfaces of the bond wafer and the base wafer are bonded each other after performing plasma treatment on the bonding interfaces, the ion-implanted layer is made brittle by heat treatment under a condition (for example, heat treatment at a low temperature of not more than 350°C) that delamination does not occur by only this heat treatment, and thereafter, the bond wafer is mechanically delaminated to form the thin film layer at a room temperature, starting from insertion of, for example, a wedge-shaped member into an outer peripheral end in the vicinity of the bonding surface (Patent Literature 3). It can be said that this method is characterized by implantation of a large amount of hydrogen ions, and plasma treatment for heightening the bonding strength and room-temperature separation. Since the surface roughness of the delamination surface can be improved by this, a load on flattening treatment after delamination can be reduced.

Similarly to this method, as another method for reducing the surface roughness of the delamination surface, there is a co-implantation method of ion-implanting both of hydrogen ions and helium ions (Patent Literatures 4, 5). This method is a method of implanting respectively both of hydrogen ions and helium ions into the bond wafer, thereafter, bonding it with the base wafer, and delaminating at the ion-implanted layer by delamination heat treatment of, for example, about 500°C, 30 minutes. The delamination is possible in dose amount that is little in comparison with the Smart-Cut method by ion-implantation of a single ion, and also the surface roughness of the delamination surface can be improved.

As described above, the method for manufacturing SOI wafer using the ion-implantation delamination method can be classified into 3 methods (the Smart-Cut method, the SiGen method, the co-implantation method).

In the above-mentioned 3 manufacturing methods, in a case where treatment of flattening the delamination surface of the SOI wafer after delamination has been performed without using Chemical Mechanical Polishing (CMP), characteristics of the quality of the manufactured SOI wafers will be shown in the following.

Although, in the Smart-Cut method, the level regarding to the SOI layer film thickness range and the terrace shape is free from problems, the surface roughness of the SOI layer surface is large in comparison with those of the other methods.

Although, in the SiGen method, the surface roughness of the SOI layer surface can be reduced, since the wedge is inserted in room-temperature separation, a film thickness distribution is greatly changed between a region where separation initially occurs and a boundary where separation occurs subsequently and the SOI layer film thickness range becomes large, and a rugged shape and chipping are generated in the terrace shape by forcedly separating them.

In the co-implantation of hydrogen and helium, although similarly to the SiGen method, the surface roughness of the SOI layer surface can be reduced, and there is no serious problem in the SOI layer film thickness range and the terrace shape, however, there is a trend that generation of voids and blister is increased under the influence of implantation of He.

The SOI wafer as a finished product to be shipped to device manufacturers, the one that is small in SOI layer film thickness range, is small in surface roughness of the SOI layer surface, is smooth in shape of the terrace part, and has no defects such as the voids, the blisters and so forth in the SOI layer is demanded.

Here, the terrace part is a region that the surface of the base wafer has been exposed without transferring the SOI layer on an outer peripheral part of the SOI wafer after delamination. And the main cause of the terrace part is that since the flatness of the wafer is worsened on an outer peripheral part of an extent of several mm of a mirror-polished wafer, the bonding strength between the wafers that have been bonded each other is weak, and the SOI layer is hardly transferred to the base wafer side. When the terrace part of this SOI wafer is observed through an optical microscope, the boundary between the SOI layer and the terrace part that is in the form of a complicated rugged shape and an SOI island that the SOI layer is isolated in the form of an islands are observed. It is thought that this occurs in a transition region between a region of favorable flatness to which the SOI layer is transferred and a region of bad flatness to which it is not transferred. It is anticipated that such rugged shape and SOI island are delaminated from the wafer in a device producing process, turn to silicon particles, again stick to a device producing region and provide cause of failure of the device(see Patent Literature 6),

Document US2011014775 provides a method for producing an SOI wafer where occurrence of thermal strain, detachment, crack and the like attributed to a difference in thermal expansion coefficients between the insulating substrate and the SOI layer is prevented. The method also improves the uniformity of film thickness of the SOI layer. The method involves a two step heating process and a delamination along an hydrogen implanted layer by applying mechanical means.

### CITATION LIST

### PATENT LITERATURES

Patent Literature 1: Japanese Unexamined Patent Publication (Kokai) No. H5-211128
Patent Literature 2: Japanese Unexamined Patent Publication (Kokai) No. 2003-347526
Patent Literature 3: Japanese Unexamined Patent Publication (Kokai) No. 2006-210898
Patent Literature 4: Japanese Unexamined Patent Publication (Translation of PCT Application) No. 2007-500435
Patent Literature 5: Japanese Unexamined Patent Publication (Translation of PCT Application) No. 2008-513989
Patent Literature 6: Japanese Unexamined Patent Publication (Kokai) No. 2002-305292

### SUMMARY OF INVENTION

### TECHNICAL PROBLEM

The present invention has been made in view of the above-mentioned circumstances, and aims to provide a method of manufacturing an SOI wafer that is small in SOI layer film thickness range, is small in surface roughness of the SOI layer surface, is smooth in shape of the terrace part, and has no defects such as the voids, the blisters and so forth in the SOI layer.

### SOLUTION TO PROBLEMS

The present invention has been made in order to solve the above-mentioned problems, the present invention provides a method for manufacturing SOI wafer, comprising steps of forming an ion implanted layer by implanting hydrogen ions from a surface of a bond wafer consisting of a silicon single crystal substrate, bonding an ion implanted surface of the bond wafer and a surface of a base wafer consisting of a silicon single crystal wafer through an oxide film, and thereafter delaminating the bond wafer at the ion implanted layer by performing delamination heat treatment, wherein,
after plasma treatment has been performed on at least one surface of a bonding interface of the bond wafer and a bonding interface of the base wafer, bonding is performed through the oxide film, wherein as the plasma treatment, nitrogen plasma treatment is performed on a wafer having the oxide film, and oxygen plasma treatment is performed on a wafer having no oxide film, and
the bond wafer is delaminated at the ion implanted layer by the delamination heat treatment comprising a first heat treatment at 250°C or less for 2 hours or more and a second heat treatment at 400°C to 450°C for 30 minutes or more.

Since the present invention performs ion implantation of only hydrogen ions into the bond wafer (helium ions are not implanted), it is not influenced by generation of the voids and the blisters caused by implantation of helium ions and has no defects such as the voids, the blisters and so forth in the SOI layer. In addition, the bonding strength is enhanced by bonding together the wafers after performing plasma treatment, thereafter, delamination is performed by performing heat treatment (the aforementioned first step and second step) that raises the temperature in 2 steps at a comparatively low temperature so as to make the ion implanted layer brittle stepwise, and thereby the surface roughness of the SOI layer surface can be made small.

In addition, since the present invention delaminates the ion implanted layer by heat treatment (not mechanically delaminating it by inserting the wedge) in delamination step, the SOI film thickness range can be made small, and the shape of the terrace part can be made smooth.

At that time, as the aforementioned plasma treatment, nitrogen plasma treatment is performed on a wafer having the oxide film, and oxygen plasma treatment is performed on a wafer having no oxide film.

In a case where bonding of the wafers has been performed by such treatment, it is preferable, in particular, because the bonding strength is heightened. In addition, the wafer that has been treated under such conditions is convenient, because wafer delamination is completed at a comparatively low temperature, and the SOI wafer that is small in surface roughness of the delamination surface can be produced.

Further, at that time, flattening treatment can be performed without performing CMP.

As such flattening treatment, for example, sacrificial oxidation treatment + Ar annealing + sacrificial oxidation treatment can be given. The SOI wafer that has been produced in this way is convenient because the film thickness uniformity of the SOI layer is particularly excellent, and the SOI film thickness range can be made further smaller.

Further, the SOI wafer that has been manufactured in this way can be made as the one that the surface roughness (RMS) of the SOI layer surface that is the delamination surface is not more than 3 nm, and the film thickness range of the SOI layer is not more than 1.5 nm.

In such an SOI wafer, since it can be made as the one that is extremely small in SOI film thickness range and surface roughness of the SOI layer surface, further is smooth in shape of the terrace part and has no defects such as the voids, the blisters and so forth in the SOI layer, it is convenient as the finished product to be shipped to the device manufacturers.

### ADVANTAGEOUS EFFECTS OF INVENTION

As described above, according to the present invention, the SOI wafer that is small in SOI layer film thickness range, is small in surface roughness of the SOI layer surface, is smooth in shape of the terrace part, and has no defects such as the voids, the blisters and so forth in the SOI layer can be manufactured.

### BRIEF DESCRIPTION OF DRAWINGS

Fig. 1 is an example of the shape of a terrace part of an SOI wafer manufactured by a method for manufacturing SOI wafer of an example 1; and
Fig. 2 is an example of the shape of a terrace part of an SOI wafer manufactured by a method for manufacturing SOI wafer of a comparative example 2.

### DESCRIPTION OF EMBODIMENTS

In the following, although a method for manufacturing SOI wafer and an SOI wafer of the present invention will be described in detail, the present invention is not limited thereto.

The present inventors, as a result of performance of keen examination, discovered that the SOI wafer that is small in SOI layer film thickness range, is small in surface roughness of the SOI layer surface, is smooth in shape of the terrace part, and has no defects such as the voids, the blisters and so forth in the SOI layer can be manufactured, by a method for manufacturing SOI wafer, comprising steps of forming an ion implanted layer by implanting hydrogen ions from a surface of a bond wafer consisting of a silicon single crystal substrate, bonding an ion implanted surface of the bond wafer and a surface of a base wafer consisting of a silicon single crystal wafer through an oxide film, and thereafter delaminating the bond wafer at the ion implanted layer by performing delamination heat treatment, wherein, after plasma treatment has been performed on at least one surface of a bonding interface of the bond wafer and a bonding interface of the base wafer, bonding is performed through the oxide film, and the bond wafer is delaminated at the ion implanted layer by the delamination heat treatment comprising a first heat treatment at 250°C or less for 2 hours or more and a second heat treatment at 400°C to 450°C for 30 minutes or more. And the present inventors have accomplished the present invention.

As described above, the present invention performs ion implantation of only hydrogen ions into the bond wafer, performs plasma treatment on at least one of the bonding surfaces of the bond wafer and the base wafer, and thereafter bonds them through the oxide film, and performs delamination heat treatment.

By performing ion implantation of only hydrogen ions on the bond wafer (without implanting helium ions) in this way, influence of generation of the voids and the blisters caused by implantation of helium ions is not exerted, and the defects such as the voids and the blisters are not generated in the SOI layer.

In addition, as described above, the present invention enhances the bonding strength of the wafers by performing plasma treatment on at least one of the bonding interfaces of the bond wafer and the base wafer, and thereafter performing delamination treatment in comparatively low-temperature heat treatment. Thereby, the present invention can make the surface roughness of the SOI layer surface small.

Here, in the delamination heat treatment of the present invention, at least 2-hour annealing is performed at not more than 250°C as the first step, and next, at least 30-minute annealing is performed in a temperature range of 400 to 450°C as the second step, thereby the ion implanted layer is made brittle and delamination is performed.

The wafer bonded after performing plasma treatment is more improved in bonding strength than a normally bonded wafer. The first embrittlement of ion implanted layer and enhancing of the bonding strength of the wafer occur by treating the wafer at not more than 250°C as the first step, thereafter, the bonding strength is more improved by 400 to 450°C heat treatment, embrittlement of the ion implanted layer is completed and wafer delamination occurs.

In the present invention, in this way, plasma treatment is performed on the wafer so as to enhance the bonding strength of the wafers, and heat treatment that raises the temperature at comparatively low-temperature in 2 steps (the aforementioned first step, second step) is performed so as to make the ion implanted layer brittle stepwise and delamination is performed, and thereby the surface roughness of the SOI layer surface can be made small.

In addition, since the present invention delaminates the ion implanted layer by heat treatment (not mechanically, forcedly delaminating it by inserting the wedge) in delamination, the SOI layer film thickness can be made small and the shape of the terrace part can be made smooth.

Incidentally, taking efficiency of delamination heat treatment into account, it is preferable that the heat treatment time in the first step and second step of delamination heat treatment be not more than 8 hours in either step, and it is more preferable that it be not more than 4 hours. Therefore, it is preferable the heat treatment temperature in the first step be at least 150°C.

The aforementioned plasma treatment is preferable to perform nitrogen plasma treatment on the wafer having the oxide film, and to perform oxygen plasma treatment on the wafer (including a wafer that only a native oxide film has been grown) with no oxide film.

By performing such plasma treatment and thereafter performing bonding of the wafers, the particularly high bonding strength can be obtained. The wafer that has been treated under such condition makes it possible to complete wafer delamination at a comparatively low temperature and in a short time, and to manufacture the SOI wafer that is further smaller in roughness of the delamination surface.

The SOI wafer just after delamination that has been manufactured in this way is small in surface roughness of the SOI layer surface, and is favorable in film thickness distribution of the SOI layer, terrace shape, and is free from generation of the blisters and the voids. In addition, since the surface roughness of the SOI layer surface is small, the SOI wafer as the finished product can make the surface roughness of the SOI layer surface sufficiently small even when performing flattening treatment only by heat treatment not using CMP.

The SOI wafer that has been manufactured in this way can be made as the one that the surface roughness (RMS) of the SOI layer surface that is the delamination surface before performing flattening treatment is not more than 3 nm, and the film thickness range of the SOI layer is not more than 1.5 nm.

The SOI wafer of high quality can be manufactured by performing flattening treatment on the delamination surface of the SOI wafer after the aforementioned delamination without performing CMP.

As flattening treatment, for example, treatment of performing sacrificial oxidation treatment + Ar annealing + sacrificial oxidation treatment can be given. The SOI wafer that has been produced in this way is convenient because the film thickness uniformity of the SOI layer is excellent, and the SOI layer film thickness range is made further smaller.

In such an SOI wafer, since the SOI layer film thickness range and the surface roughness of the SOI layer surface are extremely small, further the shape of the terrace part is smooth, and there are no defects such as the voids, the blisters and so forth in the SOI layer. Therefore, it is made high in quality as the finished product to be shipped to the device manufacturers.

### EXAMPLES

Although, in the following, the present invention will be more specifically described by showing examples, comparative examples and experimental examples, the present invention is not limited thereto.

### (Example 1)

An SOI wafer was produced by using a Si single crystal wafer of 300 mm in diameter and <100> in crystal orientation. In that occasion, a thermal oxide film of 150 nm was grown on a bond wafer in a heat treat furnace, and hydrogen ions (H⁺ ions) were ion-implanted into this wafer in dose amount of 5 × 10¹⁶/cm² and with acceleration energy of 40 keV. A base wafer consisting of a Si single crystal wafer was prepared, oxygen plasma treatment was performed only on the base wafer, and thereafter, bonding with the ion-implanted bond wafer was performed. After an annealing at 200°C for 4 hours as the first step had been performed on this bonded wafer, the temperature was raised at a rate of temperature rise of 10°C/min, and an annealing at 400°C for 6 hours as the second step was performed. The wafer was delaminated by this heat treatment and became an initial SOI wafer.

### (Comparative Example 1) (Smart-Cut Method)

An SOI wafer was produced by using a Si single crystal wafer of 300 mm in diameter and <100> in crystal orientation. In that occasion, a thermal oxide film of 150 nm was grown on a bond wafer in the heat treat furnace, and hydrogen ions (H⁺ ions) were ion-implanted into this wafer in dose amount of 5 × 10¹⁶/cm² and with acceleration energy of 40 keV. A base wafer consisting of a Si single crystal wafer was prepared and bonding with the ion-implanted bond wafer was performed (no plasma treatment). After an annealing at 350°C for 2 hours as the first step had been performed on this bonded wafer, the temperature was raised at a rate of temperature rise of 10°C/min, and an annealing at 500°C for 30 minutes as the second step was performed. The wafer was delaminated by this heat treatment and became an initial SOI wafer.

### (Comparative Example 2) (SiGen Method)

An SOI wafer was produced by using a Si single crystal wafer of 300 mm in diameter and <100> in crystal orientation. In that occasion, a thermal oxide film of 150 nm was grown on a bond wafer in the heat treat furnace, and hydrogen ions (H⁺ ions) were ion-implanted into this wafer in dose amount of 7.5 × 10¹⁶/cm² and with acceleration energy of 40 keV. A base wafer consisting of a Si single crystal wafer was prepared, oxygen plasma treatment was performed only on the base wafer, and thereafter, bonding with the ion-implanted bond wafer was performed. An annealing at 350°C for 2 hours was only performed on this bonded wafer. Wafer separation was not yet done in this state, and thereafter wafer delamination was performed using a wedge at a room temperature.

### (Comparative Example 3) (Co-Implantation Method)

An SOI wafer was produced by using a Si single crystal wafer of 300 mm in diameter and <100> in crystal orientation. In that occasion, a thermal oxide film of 150 nm was grown on a bond wafer in the heat treat furnace, and helium ions (He⁺ ions) and hydrogen ions (H⁺ ions) were ion-implanted into this wafer in dose amount of 0.9 × 10¹⁶/cm² and in dose amount of 0.9 × 10¹⁶/cm², and with acceleration energy of 40 keV. A base wafer consisting of a Si single crystal wafer was prepared, and bonding with the ion-implanted bond wafer was performed (no plasma treatment). After an annealing at 350°C for 2 hours as the first step had been performed on this bonded wafer, the temperature was raised at a rate of temperature rise of 10°C/min, and annealing at 500°C for 30 minutes as the second step was performed. The wafer was delaminated by this heat treatment and became an initial SOI wafer.

A result of evaluation of four items of the AFM roughness, the SOI layer film thickness range, the shape of the terrace part, the defects (voids, blisters) of the example 1, comparative example 1-3 was tabulated in the following Table 1.

Incidentally, the AFM roughness in Table 1 is a value that the surface roughness of a 30 µm-square region measured through an AFM (an atomic force microscope) has been expressed in RMS (Root Mean Square).

**[Table 1]**

| | AFM Roughness 30×30 µm RMS(nm) | SOI Film Thickness Range (nm) | Shape of Terrace Part | Defects (Voids, Blisters) |
|---|---|---|---|---|
| Example 1 | 2.5 | 1.3 | Favorable | None |
| Comparative Example 1 | 5.3 | 1.1 | Favorable | None |
| Comparative Example 2 | 2.5 | 2.1 | Noticeable ruggedness | None |
| Comparative Example 3 | 3.1 | 1.2 | Favorable | Generated by 2-3% |

In regard to the AFM roughness, Comparative Example 1 results in about two times as large as the other examples, the surface roughness is large and it can be anticipated that a load will be exerted onto a subsequent flattening process.

In regard to the film thickness distribution, only Comparative Example 2 had become large. The cause therefor lies in that when performing wafer separation, wafer separation occurs around the wedge at the moment that the wedge has been inserted, and thereafter wafer separation is performed by further advancing the wedge in a central direction of the wafer. The film thickness is sharply changed at a boundary between this initially wafer separated region and a subsequently separated region. This is a cause for large film thickness distribution.

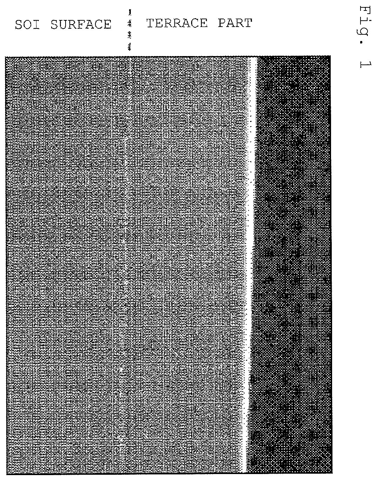

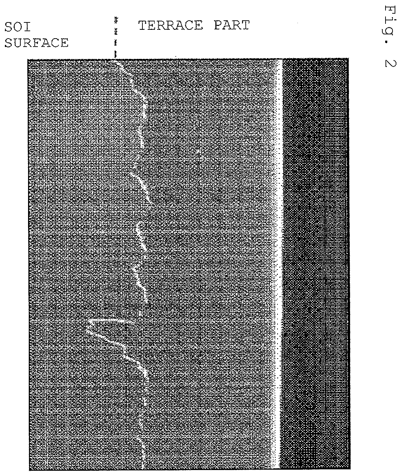

In regard to the shape of the terrace part, noticeable ruggedness was generated only in Comparative Example 2 (Fig. 2). It is thought that this is because mechanical compelling force is exerted by forcedly performing wafer separation by using the wedge at the room temperature. In comparison with it, the shapes of the terrace parts in other examples are favorable (Fig. 1). It is thought that the rugged shape is not generated because delamination occurs smoothly by heat treatment.

In regard to generation of the defects, they were generated only in Comparative Example 3. It is thought that ion implantation of He (helium) and H (hydrogen) is performed and it leads to performance of treatment two times in a process that particle adhesion is the most liable to occur in the manufacturing process, and therefore particle-induced generation of voids and blisters is more increased than other examples. Incidentally, though not shown in the table, although generation of the blisters was reduced in other examples that had been performed under the same conditions as Comparative Example 3 excepting that the plasma treatment was performed before bonding, generation of the voids was increased and there was no change in total number of defects of the voids and the blisters.

### <Experimental Examples>

### (Experimental Example 1)

An experiment that the first step and the second step for wafer separation (delamination) are combined was performed under the following conditions.

An SOI wafer was produced by using Si single crystal wafers of 300 mm in diameter and <100> in crystal orientation as a bond wafer and a base wafer.

First, a thermal oxide film of 150 nm was grown on the bond wafer in the heat treat furnace. Hydrogen was ion-implanted into this wafer in dose amount of 5 × 10¹⁶/cm² and with acceleration energy of 40 keV. The base wafer (with no oxide film) was prepared, nitrogen plasma treatment was performed on the base wafer, and thereafter bonding was performed. As delamination heat treatment, 2-hour annealing was performed on this bonded wafer within a range of 150 to 350°C as the first step, the temperature was raised at 10°C /min, and 350 to 500°C annealing was performed as the second step (see Table 2 for heat treatment conditions of the first step, the second step). By this heat treatment, it was delaminated at the ion implanted layer and an initial SOI wafer was produced (there are the ones that cannot be delaminated depending on the heat treatment condition). A sacrificial oxidation treatment at 900°C for 2 hours(thermal oxidation + oxide film removal), an annealing at 1200°C for 1 hour under an Ar atmosphere, and 950°C sacrificial oxidation treatment for film thickness adjustment were sequentially performed on this initial SOI wafer so as to produce finished products of the SOI wafer of 88 nm in SOI layer film thickness, and the surface roughness (RMS) of the SOI layer surfaces thereof was measured and compared through the AFM within a range of 30 µm × 30 µm. A result is shown in the following Table 2.

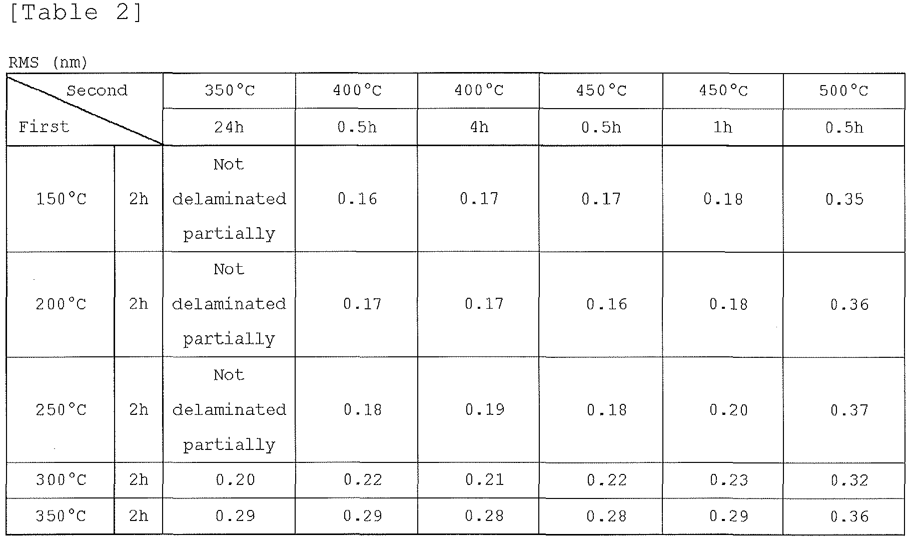

The surface roughness (RMS) of the SOI layer surface when heat treatment was performed for 2 hours within a range of 150°C to 250°C as the first step, and heat treatment was performed for at least 30 minutes and not more than 4 hours at 400°C to 450°C as the second step is extremely small.

### (Experimental Example 2)

Finished products of the SOI wafer were produced under the same conditions as in Experimental Example 1 excepting that the heat treatment time in the first step was set to 4 hours, and the second step was set to 3 conditions of 350°C and 4 hours, 400°C and 0.5 hours, 450°C and 0.5 hours were set, and the surface roughness (RMS) of the SOI layer surfaces thereof was measured and compared through the AFM within the range of 30 µm × 30 µm. A result is shown in the following Table 3.

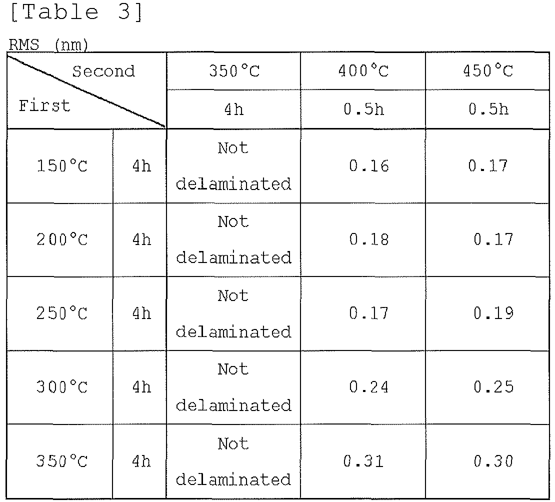

The surface roughness (RMS) of the SOI layer surface when heat treatment was performed for 4 hours within a range of 150°C to 250°C as the first step, and heat treatment was performed for 30 minutes at 400°C to 450°C as the second step is extremely small. Incidentally, when the heat treatment temperature in the second step after heat treatment in the first step is 350°C (less than 400°C), delamination itself did not occur even when heat treatment was performed for 4 hours.

### (Experimental Example 3)

Finished products of the SOI wafer were produced under the same conditions as in Experimental Example 1 excepting that the heat treatment time in the first step was set to 1 hour, and the second step was set to 2 conditions of 350°C and 4 hours, 400°C and 0.5 hours, and the surface roughnesses (RMS) of the SOI layer surfaces thereof were measured and compared through the AFM within the range of 30 µm × 30 µm. A result is shown in the following Table 4.

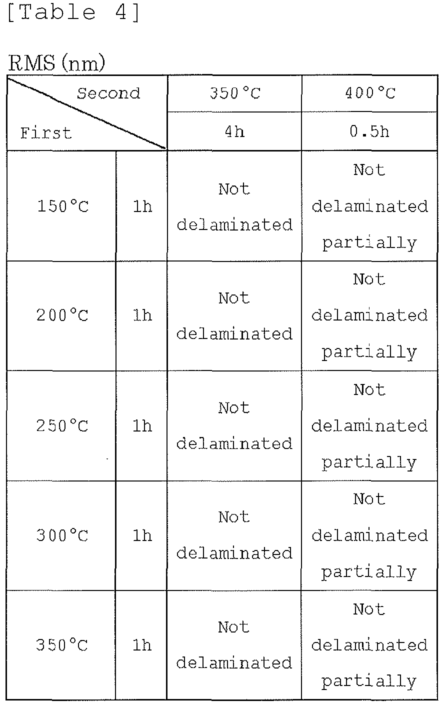

The result was such that when the heat treatment time in the first step is 1 hour (less than 2 hours), the wafer is not delaminated partially even when heat treatment is performed for 30 minutes at 400°C in the second step. In addition, when the heat treatment time in the first step is 1 hour (less than 2 hour) and the heat treatment temperature in the second step is 350°C (less than 400°C), delamination itself did not occur even when heat treatment was performed for 4 hours.

### (Experimental Example 4)

Finished products of the SOI wafer were produced under the same conditions (some conditions were not performed) as in Experimental Example 1 excepting that plasma treatment is not performed before bonding , and the surface roughness (RMS) of the SOI layer surfaces thereof was measured and compared through the AFM within the range of 30 µm × 30 µm. A result is shown in the following Table 5.

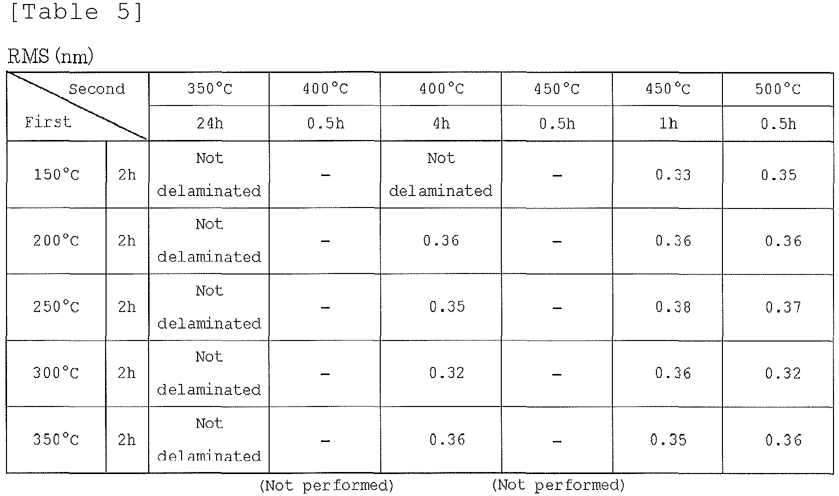

Even when heat treatment was performed for 2 hours within a range of 150°C to 250°C as the first step and heat treatment was performed for 4 hours at 400°C, or 1 hour at 450°C as the second step, the wafer was not delaminated or the surface roughness (RMS) of the SOI layer surface was large although it had been delaminated, unless plasma treatment was performed before bonding.

### (Experimental Example 5)

In order to confirm the effects of the plasma treatment conditions, finished products of the SOI were produced under the following conditions.

SOI was produced by using Si single crystal wafers of 300 mm in diameter and <100> in crystal orientation as the bond wafer and the base wafer.

First, a thermal oxide film of 150 nm was grown on the bond wafer in the heat treat furnace. Hydrogen was ion-implanted into this bond wafer in dose amount of 5 × 10¹⁶/cm² and with acceleration energy of 40 keV. The base wafer (with no oxide film) was prepared, plasma treatment was performed on both of them, and thereafter they were bonded each other.

Plasma conditions were as in the following Table 6.

**[Table 6]**

| | Bond Wafer (with oxide film) | Base Wafer (without oxide film) |
|---|---|---|
| Condition (1) | Nitrogen Plasma | Nitrogen Plasma |
| Condition (2) | Nitrogen Plasma | Oxygen Plasma |
| Condition (3) | Oxygen Plasma | Nitrogen Plasma |
| Condition (4) | Oxygen Plasma | Oxygen Plasma |

As delamination heat treatment, after an annealing at 200°C for 4 hours had been performed on this bonded wafer as the first step, the temperature was then raised at the rate of temperature rise of 10°C /min, and thereafter an annealing at 400°C for 4 hours was performed as the second step. By this heat treatment, it was delaminated at the ion implanted layer, and an initial SOI wafer was produced. Thereafter an sacrificial oxidation treatment at 900°C for 2 hours, an annealing at 1200°C for 1 hour under the Ar atmosphere, and 950°C sacrificial oxidation treatment for film thickness adjustment were sequentially performed on this initial SOI wafer so as to produce finished products of the SOI wafer of 88 nm in SOI layer film thickness, and the surface roughness (RMS) of the SOI layer surfaces thereof was measured and compared through the AFM within the range of 30 µm × 30 µm.

The surface roughness (RMS) were made as follows.

| | |
|---|---|
| Condition (1) | 0.17 nm |
| Condition (2) | 0.14 nm |
| Condition (3) | 0.17 nm |
| Condition (4) | 0.15 nm |

From the above, it was found that the surface roughness (RMS) becomes the smallest by treating the oxide film with nitrogen plasmas and the wafer with no oxide film with oxygen plasmas.

Incidentally, the present invention, the above mentioned embodiment is illustrative and ones having configurations that are substantially the same as the technical ideas described in the scope of patent claims of the present invention and exhibiting the same operational effects are included in the technical scope of the present invention which is defined by the appended claims.

## Claims

1. A method for manufacturing SOI wafer, comprising steps of forming an ion implanted layer by implanting hydrogen ions from a surface of a bond wafer consisting of a silicon single crystal substrate, bonding an ion implanted surface of the bond wafer and a surface of a base wafer consisting of a silicon single crystal wafer through an oxide film, and thereafter delaminating the bond wafer at the ion implanted layer by performing delamination heat treatment, wherein,
after plasma treatment has been performed on surfaces of a bonding interface of the bond wafer and a bonding interface of the base wafer, bonding is performed through the oxide film,
wherein as the plasma treatment, nitrogen plasma treatment is performed on a wafer having the oxide film, and oxygen plasma treatment is performed on a wafer having no oxide film, and
the bond wafer is delaminated at the ion implanted layer by the delamination heat treatment comprising a first heat treatment at 250°C or less for 2 hours or more and a second heat treatment at 400°C to 450°C for 30 minutes or more.

2. The method for manufacturing SOI wafer according to claim 1, wherein flattening treatment without CMP is performed on a delamination surface of the SOI wafer after the delamination.

## Patentansprüche

1. Verfahren zur Herstellung eines SOI-Wafers, umfassend die Schritte des Bildens einer ionenimplantierten Schicht durch Implantieren von Wasserstoffionen von einer Oberfläche eines Bondwafers, der aus einem Silizium-Einkristallsubstrat besteht, des Verbindens einer ionenimplantierten Oberfläche des Bondwafers und einer Oberfläche eines Basiswafers, der aus einem Silizium-Einkristallwafer besteht, durch einen Oxidfilm, und danach des Delaminierens des Bondwafers an der ionenimplantierten Schicht durch Durchführen einer Delaminierungswärmebehandlung, wobei,
nachdem eine Plasmabehandlung an den Oberflächen einer Bondgrenzfläche des Bondwafers und einer Bondgrenzfläche des Basiswafers durchgeführt wurde, wird das Bonden durch den Oxidfilm durchgeführt,
wobei als Plasmabehandlung eine Stickstoffplasmabehandlung an einem Wafer mit dem Oxidfilm durchgeführt wird und eine Sauerstoffplasmabehandlung an einem Wafer ohne Oxidfilm durchgeführt wird, und
der Bondwafer an der ionenimplantierten Schicht durch die Delaminationswärmebehandlung delaminiert wird, die eine erste Wärmebehandlung bei 250°C oder weniger für 2 Stunden oder mehr und eine zweite Wärmebehandlung bei 400°C bis 450°C für 30 Minuten oder mehr umfasst.

2. Verfahren zur Herstellung eines SOI-Wafers nach Anspruch 1, wobei eine Glättungsbehandlung ohne CMP auf einer Delaminationsoberfläche des SOI-Wafers nach der Delamination durchgeführt wird.

## Revendications

1. Procédé de fabrication d'une plaquette de SOI, comprenant les étapes de formation d'une couche à implantation ionique par implantation d'ions hydrogène à partir d'une surface d'une plaquette de liaison constituée d'un substrat de silicium monocristallin, liaison d'une surface à implantation ionique de la plaquette de liaison et d'une surface d'une plaquette de base constituée d'une plaquette de silicium monocristallin par l'intermédiaire d'un film d'oxyde, et ensuite délaminage de la plaquette de liaison au niveau de la couche à implantation ionique par réalisation d'un traitement thermique de délaminage, dans lequel,
après que le traitement au plasma ait été effectué sur des surfaces d'une interface de liaison de la plaquette de liaison et d'une interface de liaison de la plaquette de base, une liaison est réalisée par l'intermédiaire du film d'oxyde,
dans lequel, en tant que traitement au plasma, un traitement au plasma d'azote est effectué sur une plaquette ayant le film d'oxyde, et un traitement au plasma d'oxygène est effectué sur une plaquette n'ayant pas de film d'oxyde, et
la plaquette de liaison est délaminée au niveau de la couche à implantation ionique par le traitement thermique de délaminage comprenant un premier traitement thermique à 250 °C ou moins pendant 2 heures ou plus et un second traitement thermique à 400 °C à 450 °C pendant 30 minutes ou plus.

2. Procédé de fabrication de plaquette de SOI selon la revendication 1, dans lequel un traitement d'aplanissement sans CMP est réalisé sur une surface de délaminage de la plaquette de SOI après le délaminage.
